# EUROPEAN PATENT APPLICATION

(11) **EP 4 815 505 A1**
(43) Date of publication of application: **30.09.2026**
(21) Application number: 25167037.8
(22) Date of filing: 28.03.2025
(51) Int. Cl.: H04R 19/04

(54) **MEMS DEVICE**

(71) Applicant: Infineon Technologies AG, 85579 Neubiberg (DE)
(72) Inventor: FÜLDNER, Marc, 85579 Neubiberg (DE)
(74) Representative: Hersina, Günter

(57) **Abstract**

MEMS device (10) comprising: a transducer element (12) having a first deflectable membrane structure (14), a rigid electrode structure (16) and a second deflectable membrane structure (18) in a vertically spaced configuration, wherein the rigid electrode structure (16) is arranged between the first and second deflectable membrane structure (14, 18), the first and second deflectable membrane structure (14, 18) each comprise a deflectable portion (14-1, 18-1), and wherein the deflectable portion (14-1) of the first deflectable membrane structure (14) and the deflectable portion (18-1) of the second deflectable structure (18) are mechanically coupled by means of mechanical connection elements (20) to each other and are mechanically decoupled from the rigid electrode structure (16); a carrier element (22) for supporting the transducer element (12); a plurality of first clamping structures (24-1, ..., 24-#) for mechanically connecting the transducer element (12) to the carrier element (22) at edge clamping regions (26-1, ..., 26-#) of the transducer element (12); an elongation structure (32) laterally extending from unclamped edge regions (34-1, ..., 34-#) of the transducer element (12); a plurality of second clamping structures (36-1, ..., 36-#) for mechanically connecting the elongation structure (30) to the carrier element (22) at edge clamping regions (38-1, ..., 38-#) of the elongation structure (32); and wherein the elongation structure (32) comprises first elongation elements (40) which extend at least partially in the same plane as the first deflectable membrane structure (14) from the transducer element (12) to the second clamping structures (36-1, ..., 36-#), or wherein the elongation structure (32) comprises second elongation elements (42) which extend at least partially in the same plane as the second deflectable membrane structure (18) from the transducer element (12) to the second clamping structures (36-1, ..., 36-#).

## Description

Embodiments of the present disclosure relate to a MEMS device (MEMS = micro electromechanical system). More specifically, embodiments relate to the field of MEMS sound transducers (MEMS microphones or MEMS loudspeakers), e.g. a sealed dual membrane (SDM) microphone or loudspeaker, with a semi-bridge design, having a plurality of first clamping structures for connecting the transducer element to the carrier element, an elongation structure and a plurality of second clamping structures for connecting the elongation structure to the carrier element.

### Technical Background

The sensing of environmental parameters in the ambient atmosphere, such as sound with MEMS-based devices gains more and more importance in the implementation of appropriate sensors within mobile devices, home automation systems, such as Smart Home, and the automotive sector. MEMS devices, such as MEMS sound transducers (MEMS microphones or MEMS loudspeakers) function essentially as a transducer element capacitively converting an acoustic pressure wave into an analog electrical signal. The sound transducing mechanism in the MEMS microphone involves a variable capacitor having a fixed plate (back-plate or counter electrode) and at least one deflectable plate (membrane).

When designing capacitive MEMS devices, e.g. sound transducers (microphones or loudspeakers), it may be typically desirable to achieve a high signal-to-noise ratio (SNR) of the transducer output signal. The continuous miniaturization of transducers may pose new challenges with respect to the desired high signal-to-noise ratio.

As semiconductor technologies make further progress, a sealed dual-membrane (SDM) microphone has emerged to further improve key performance characteristics such as low noise and reliability. The SDM microphone typically comprises a top membrane, a bottom membrane, a perforated stator, a top oxide structure between the peripheral portions of the top membrane and the stator, a bottom oxide structure between the peripheral portions of the bottom membrane and the stator, and at least one pillar coupled between the top membrane and the bottom membrane. In conventional a SDM MEMS microphone, the transducer element is mechanically anchored by means of a further oxide structure along the entirety of its perimeter. However, since the membranes are anchored around the entire perimeter, the mechanical compliance and as such the SNR (signal-to-noise ratio) might be limited. To increase the membrane compliance, the membranes could be anchored at specific areas only, As an example, in a "bridge" like design two sides of a cantilever are anchored while the two long side are free to move. However, this design may be prone to contaminations from the environment, such as clogging (or blocking) of the free moving side areas. This may lead to a significant deterioration of operational characteristics of the microphone, such as a relatively low sensitivity and SNR, and further resulting in a relatively low robustness and durability.

Therefore, there is an ongoing need in the field of MEMS devices, e.g., of MEMS transducers, to implement a MEMS device having further improved mechanical, operational and electrical characteristics, e.g., for providing a further improved performance with an increased sensitivity and/or SNR of the MEMS device, which is less prone to (or more robust against) to contamination, e.g. from contaminants such as particulate matter, and thus can avoid a significant deterioration of its operational characteristics and achieve an improved robustness and durability.

Such a need can be solved by the MEMS device according to independent claim 1. Further, specific implementations of the MEMS device are defined in the dependent claims.

### Summary

According to embodiments, a MEMS device comprises a transducer element (e.g. microphone or loudspeaker) having a first deflectable membrane structure, a rigid electrode structure (e.g. a stator or back-plate) and a second deflectable membrane structure in a vertically spaced configuration The rigid electrode structure is arranged between the first and second deflectable membrane structure, wherein the first and second deflectable membrane structures each comprise a deflectable portion, and wherein the deflectable portion of the first deflectable membrane structure and the deflectable portion of the second deflectable membrane structure are mechanically coupled by means of mechanical connection elements (e.g. pillars or columns) to each other and are mechanically decoupled from the rigid electrode structure. The MEMS device further comprises a carrier element for supporting the transducer element, a plurality of clamping structures for mechanically connecting (e.g. anchoring, or mechanically coupling) the transducer element to the carrier element at (e.g. along) edge clamping regions of the transducer element. The MEMS device further comprises an elongation structure laterally extending from unclamped edge regions of the transducer element and a plurality of second clamping structures for mechanically connecting (e.g. anchoring, or mechanically coupling) the elongation structure to the carrier element at (e.g. along) edge clamping regions of the elongation structure. The elongation structure comprises first elongation elements which extend at least partially in the same plane as the first deflectable membrane structure from the transducer element to the second clamping structures, or, the elongation structure comprises second elongation elements which extend at least partially in the same plane as the second deflectable membrane structure from the transducer element to the second clamping structure.

According to embodiments, wherein the elongation structure may comprise first elongation elements which extend at least partially in the same plane as the first deflectable membrane structure from the transducer element to the second clamping structures, and wherein the elongation structure may comprise second elongation elements which extend at least partially in the same plane as the second deflectable membrane structure from the transducer element to the second clamping structures.

According to embodiments, wherein the transducer element may be mechanically decoupled from the carrier element at the unclamped edge regions.

According to embodiments, wherein the first elongation elements may be formed as lateral elongations of the first deflectable membrane structure.

According to embodiments, wherein the second elongation elements may be formed as lateral elongations of the second deflectable membrane structure.

According to embodiments, wherein the MEMS device may further comprise a wall structure at the unclamped edge regions of the transducer element.

The present disclosure describes a MEMS device which, for example, may be a MEMS sound transducer, e.g. a SDM MEMS microphone or loudspeaker, with a significantly increased mechanical compliance, which results in an significantly increased mechanical sensitivity (when compared to conventional SDM microphone of the same physical dimensions) along with a significantly increased robustness and durability, thus being relatively less prone (or less susceptible) to (or more robust against) contamination thereby avoiding a significant deterioration of its operational characteristics.

Thus, the present approach of the MEMS device with the semi-bridge (or half-bridge) design allows to achieve a relatively high compliance of the membrane arrangement, in particular, of a sealed dual membrane (SDM) microphone with two coupled membrane structures and an elongation structure, while being more resistant or less susceptible to (external) contamination from the environment.

Thus, the MEMS device with the semi-bridge design (comprising the elongation structure) may provide robust and contaminant-proof (e.g. particulate-matter-proof) MEMS devices, e.g., MEMS microphones, without relying on an external protection structure, such as an external environmental barrier, for preventing contaminants (e.g. particulate matter) from interfering in the MEMS device's operation.

Thus, the MEMS device achieves enhanced sensitivity and SNR and increased robustness against external, or environmental contamination, therewith allowing an improved trade-off between the former and the latter. In other words, the half-bridge design (comprising the elongation structure) provides an improved and durable performance of the MEMS device, e.g. a SDM MEMS microphone. In particular, a high mechanical compliance, also referred to as membrane compliance or mechanical sensitivity and defined as the displacement amplitude of the membrane per unit incident sound pressure, and a high robustness or durability are important attributes for high operational performance of SDM MEMS microphones.

### Brief Description of the Figures

In the following, embodiments of the present disclosure are described in more detail while making reference to the accompanying drawings, in which:
- Figs. 1a-d: show a schematic top (plane) view, a schematic oblique view and two different schematic cross-sectional views of a MEMS device in accordance with embodiments of the present disclosure;
- Figs. 2a-b: show schematic cross-sectional views of the MEMS device with further exemplary implementations of the elongation structure of the MEMS device in accordance with further embodiments of the present disclosure,
- Figs. 3a-d: show schematic views of different implementations of "stress relief structures" comprised in the elongation structure of the MEMS device in accordance with further embodiments of the present disclosure; and
- Figs. 4a-d: show schematic top (plane) views of the MEMS device with further exemplary implementations of the semi-bridge design of a MEMS device, e.g. a SDM microphone, in accordance with further embodiments of the present disclosure.

Before discussing the present embodiments in further detail using the drawings, it is pointed out that in the figures and the specification identical elements and elements having the same functionality and/or the same technical or physical effect are usually provided with the same reference numbers or are identified with the same name, so that the description of these elements and of the functionality thereof as illustrated in the different embodiments are mutually exchangeable or may be applied to one another in the different embodiments.

### Detailed Description of the Figures

In the following description, embodiments are discussed in detail, however, it should be appreciated that the embodiments provide many applicable concepts that can be embodied in a wide variety of the field of dual-membrane MEMS devices. The specific embodiments discussed are merely illustrative of specific ways to implement and use the present concept, and do not limit the scope of the embodiments. In the following description of embodiments, the same or similar elements or elements that have the same functionality are provided with the same reference sign or are identified with the same name, and a repeated description of elements provided with the same reference number or being identified with the same name is typically omitted. In the following description, a plurality of details is set forth to provide a more thorough explanation of embodiments of the disclosure.

However, it will be apparent to one skilled in the art that other embodiments may be practiced without these specific details. In other instances, well-known structures and devices are shown in block diagram form rather than in detail in order to avoid obscuring examples described herein. In addition, features of the different embodiments described herein may be combined with each other, unless specifically noted otherwise.

It is understood that when an element is referred to as being "connected" or "coupled" to another element, it may be directly connected or coupled to the other element, or intermediate elements may be present. Conversely, when an element is referred to as being "directly" connected to another element, "connected" or "coupled," there are no intermediate elements. Other terms used to describe the relationship between elements should be construed in a similar fashion (e.g., "between" versus "directly between", "adjacent" versus "directly adjacent", and "on" versus "directly on", etc.).

For facilitating the description of the different embodiments, the figures comprise a Cartesian coordinate system x, y, z, wherein the x-y-plane corresponds, i.e. is parallel, to a first main surface region of a carrier element (or a substrate) (= a reference plane = x-y-plane), wherein the direction vertically up with respect to the reference plane (x-y-plane) corresponds to the "+z" direction, and wherein the direction vertically down with respect to the reference plane (x-y-plane) corresponds to the "-z" direction. In the following description, the term "lateral" means a direction parallel to the x- and/or y-direction, i.e. parallel to the x-y-plane, wherein the term "vertical" means a direction parallel to the z-direction.

In the following description, a thickness of an element usually indicates a vertical dimension of such an element. In the figures, the different elements are not necessarily drawn to scale. Thus, the illustrated dimensions of the different elements may not be necessarily drawn to scale.

In the description of the embodiments, terms and text passages placed in brackets (next to a described element or function) are to be understood as further explanations, exemplary configurations, exemplary additions and/or exemplary alternatives of the described element or function.

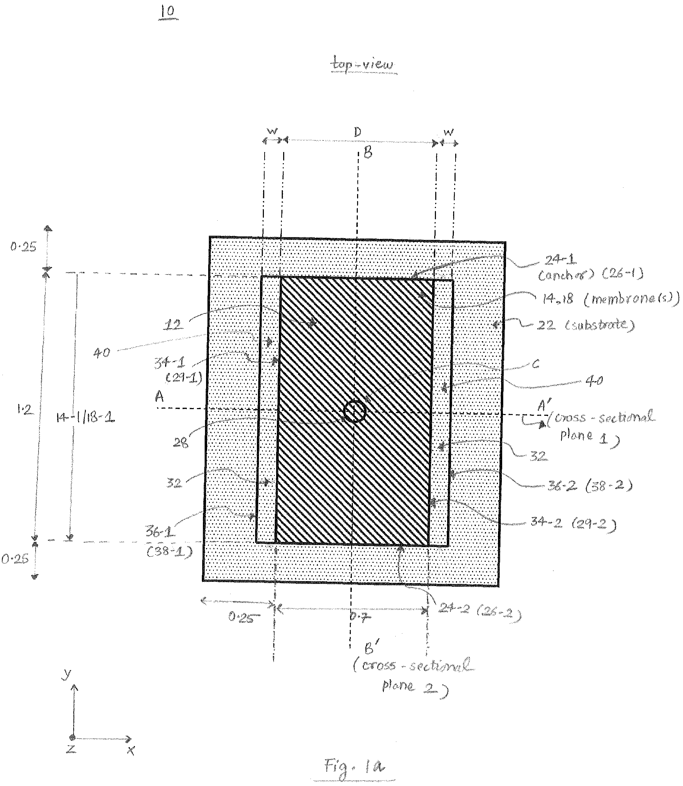

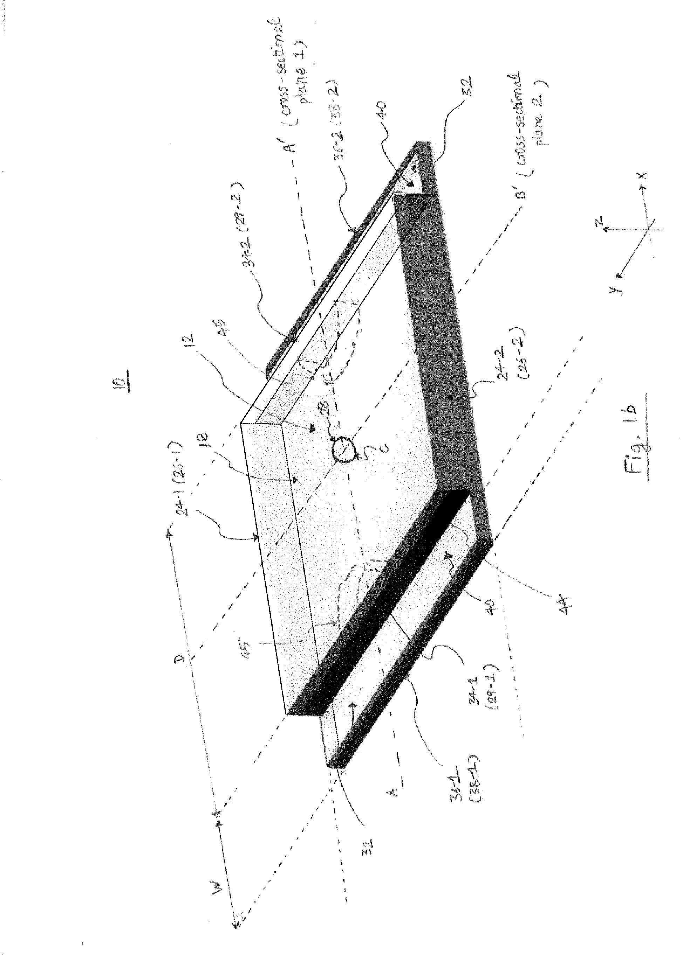

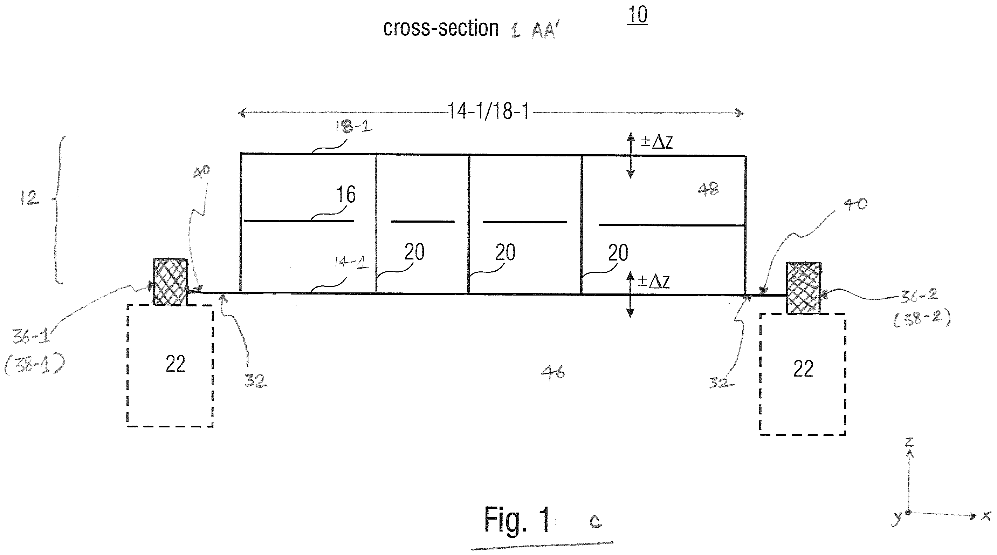

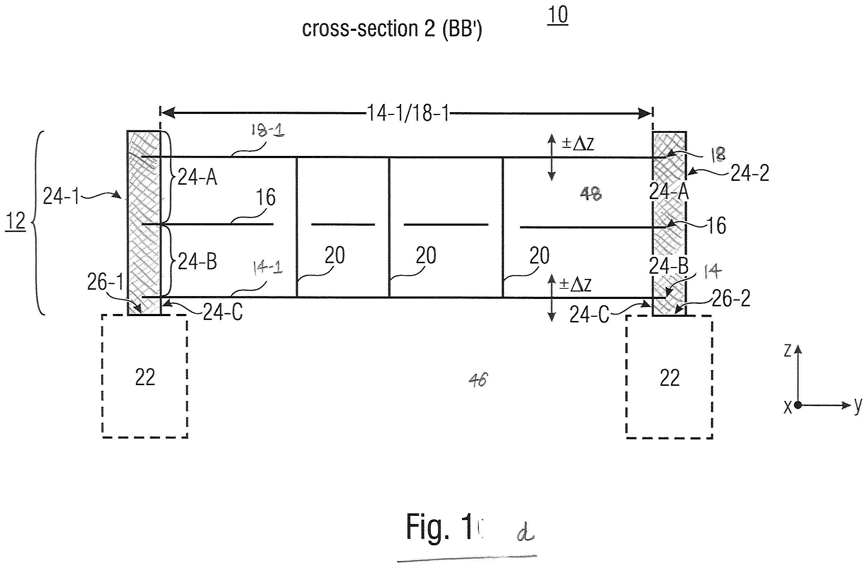

Fig. 1a exemplarily shows a schematic top view (parallel to the x-y-plane) of an exemplary MEMS device 10, Fig. 1b exemplarily shows a schematic oblique view (oblique or angled to the x-y plane), Fig. 1c exemplarily shows a schematic cross-sectional view (parallel to the x-z plane) along a sectional line AA' (= cross-sectional plane 1) of the exemplary MEMS device 10, and Fig. 1d exemplarily shows a further schematic cross-sectional view (parallel to the y-z plane) along a further sectional line BB' (= cross-sectional plane 2) of the exemplary MEMS device 10.

As shown in Figs. 1a-d, the MEMS device 10 comprises a (sound) transducer element (e.g. a sound transducer element such as a microphone element or a loudspeaker element) 12 having a first deflectable membrane structure 14, a rigid electrode structure (e.g. stator or back-plate) 16 and a second deflectable membrane structure 18 in a vertically spaced configuration, wherein the rigid electrode structure 16 is arranged between the first deflectable membrane structure 14 and the second deflectable membrane structure 18. The first deflectable membrane structure 14 and second deflectable membrane structure 18 each comprise a deflectable portion 14-1, 18-1, and wherein the deflectable portion 14-1 of the first deflectable membrane structure 14 and the deflectable portion 18-1 of the second deflectable membrane structure 18 are mechanically coupled by means of mechanical connection elements (e.g. in form of pillars or columns) 20 to each other and are mechanically decoupled from (= deflectable with respect to) the rigid electrode structure 16.

The MEMS device 10 further comprises a carrier element 22 for supporting (e.g. mechanically bearing) the transducer element 12. The carrier element 22 may comprise a substrate or a semiconductor (e.g. Si) substrate. The MEMS device 10 further comprises a plurality of first clamping structures (or, e.g., anchor structures ) 24-1, 24-2 for mechanically connecting (e.g. anchoring) the transducer element 12 to the carrier element 22 along edge clamping regions (e.g. spaced clamping regions) 26-1, 26-2 of the transducer element 12. That is, the transducer element 12 is anchored, or attached, along its edge clamping regions 26-1, 26-2 by the first clamping structures 24-1, 24-2. Therefore, the edge clamping regions 26-1, 26-2 refer to the portions or regions defined along edges (e.g. lateral edges) of the transducer element 12 where it is mechanically fixed by the first clamping structures 24-1, ..., 24-#. Such regions may be spatially separated from each other, that is, they may be spatially discontinuous. In other words, the edge clamping regions of the transducer element may be defined as spaced/spatially separated regions along a (lateral) boundary, or a (lateral) perimeter of the transducer element 12, the (lateral) perimeter being defined in a plane parallel to a main outer surface of the transducer element 12 or of the carrier element 22, as expressly visible in the top view of Fig. 1a.

The MEMS device 10 as exemplarily shown Figs. 1a-d comprises two (laterally opposite) clamping or anchor structures 24-1, 24-2 for mechanically connecting (anchoring) the transducer element 12 to the carrier element 22 along the spaced perimeter regions 26-1, 26-2 of the transducer element 12.

As exemplarily shown Figs. 1a-d, the MEMS device 10 further comprises an elongation structure 32 which laterally extends from unclamped edge regions 34-1, 34-2 of the transducer element 12. In other words, the elongation structure 32 (laterally) protrudes from the unclamped edge regions 34-1, 34-2 of the transducer element 12. That is, the transducer element 12 is not anchored, or unattached, along its unclamped edge regions 26-1, 26-2. Therefore, the unclamped edge regions 26-1, 26-2 refer to the portions or regions defined along edges (e.g. lateral edges) of the transducer element 12 where it is not mechanically fixed (i.e. where the first clamping structures 24-1, 24-2 are absent). Such regions may be spatially separated from each other, that is, they may be spatially discontinuous. In other words, the unclamped edge regions of the transducer element may be defined as spaced/spatially separated portions/regions along a (lateral) boundary, or a (lateral) perimeter of the transducer element 12, the (lateral) perimeter being defined in a plane parallel to a main outer surface of the transducer element 12 or of the carrier element 22, as expressly visible in the top view of Fig. 1a.

For instance, as shown in Figs. 1a-d, the elongation structure 32 is symmetrically arranged with respect to the transducer element 12. More specifically, the elongation structure 32 comprising a (lateral) width w is arranged adjacent to the unclamped edge regions 34-1, 34-2 of the transducer element, that is, the elongation structure 32 (laterally) spans out from both the unclamped edge regions 34-1, 34-2 of the transducer element 12.

The MEMS device 10 further comprises a plurality of second clamping structures 36-1, 36-2 for mechanically connecting the elongation structure 32 to the carrier element at edge clamping regions 38-1, 38-2 of the elongation structure 32. That is, the elongation structure 32 is anchored, or attached, along its edge clamping regions 36-1, 36-2 by the second clamping structures 24-1, 24-2. Therefore, the edge clamping regions 36-1, 36-2 refer to the portions or regions defined along edges (e.g. lateral edges) of the elongation structure 32 where it is mechanically fixed by the second clamping structures 36-1, 36-2. Such regions may be spatially separated from each other, that is, they may be spatially discontinuous. In other words, the edge clamping regions of the elongation structure may be defined as spaced/spatially separated regions along a (lateral) boundary, or a (lateral) perimeter of the elongation structure 32, the (lateral) perimeter being defined in a plane parallel to a main outer surface of the transducer element 12 or of the carrier element 22, as expressly visible in the top view of Fig. 1a.

Thus, according to embodiments, the (sound) transducer element 12 of the MEMS device 10 is mechanically anchored (coupled) along at least two edge (clamping) regions (or lateral perimeter/boundary regions) 26-1, 26-2 of the transducer element 12 and further, the elongation structure 32 extends away (or protrudes from) at least two unclamped edge regions (or unclamped lateral perimeter/boundary regions) 34-1, 34-2 of the transducer element 12 (in contrast to a conventional SDM MEMS microphone which does not comprise an elongation structure). This configuration or arrangement of the MEMS device 10 improves the compliance and, thus, the mechanical sensitivity of the membrane arrangement having the mechanically coupled first and second deflectable membrane structures 14, 18, and, hence, the overall operational performance of the MEMS device.

As clearly shown in Figs. 1b-d, the elongation structure 32 comprises first elongation elements 40, which extend, at least partially in the same plane as the first deflectable membrane structure 14, from the transducer element 12 to the second clamping structures 36-1, 36-2. In particular, Figs. 1a-d show that the elongation structure 32 comprises two first elongation elements 40 laterally adjacent to the transducer element 12.

In accordance with embodiments, it could be preferred that the elongation structure may comprise the first elongation elements which extend, entirely in the same plane as the first deflectable membrane structure, from the transducer element to the second clamping structures.

As shown in Figs. 1a-d, along and laterally between the unclamped edge regions (or unclamped spaced perimeter regions) 34-1, 34-2, the transducer element 12 is mechanically decoupled (unclamped or unattached) from the carrier element 22 and, thus, displaceable (deflectable) with respect to the carrier element 22. Thus, in accordance with embodiments, the transducer element 12 is mechanically decoupled from the carrier element 12 at the unclamped edge regions 34-1, 34-2.

Further, along and laterally between the (respective) second clamping structures 36-1, 36-2 and the (respective) unclamped edge regions (or unclamped spaced perimeter regions) 34-1, 34-2, the elongation structure 32 is mechanically decoupled (unclamped or unattached) from the carrier element 22, and thus, also displaceable (deflectable) with respect to the carrier element 22.

To be more specific, the deflectable portion 14-1 of the first deflectable membrane structure 14 and the deflectable portion 18-1 of the second deflectable membrane structure 18 of the transducer element 12 extend between the (laterally) opposing first clamping (anchor) structures 24-1, 24-2 (at the spaced perimeter regions 26-1, 26-2) and are further mechanically decoupled from the carrier element 22 and, thus, displaceable (deflectable) with respect to the carrier element 22.

Further, in accordance with embodiments, the first elongation elements 40 of the elongation structure 32 may be formed as lateral elongations of the first deflectable membrane structure 14. These lateral elongations may extend from the unclamped edge regions 34-1, 34-2 of the transducer element 12 towards the respective second clamping structures 36-1, 36-2 and may further be mechanically decoupled from the carrier element 22 and, thus, may be displaceable (deflectable) with respect to the carrier element 22.

It can be clearly seen in Figs. 1a-d that the edge clamping regions 26-1, 26-2 of the transducer element 12 and the edge clamping regions 38-1, 38-2 of the elongation structure 32 are arranged in an alternating order. In other words, the edge clamping regions 38-1, 38-2 of the elongation structure 32 are (laterally) in between the edge clamping regions 26-1, 26-2 of the transducer element 12.

As clearly shown in Figs. 1a-b, each of plurality of the second clamping structures 36-1, 36-2 comprise first portions (laterally) extending parallel to (e.g. or extending along) the edge clamping regions 26-1, 26-2 of the transducer element 12 and second portions (laterally) extending parallel to the unclamped edge regions 34-1, 34-2 of the transducer element 12. Together the first portions and the second portions span the (lateral) outer perimeter or boundary of the elongation structure 32.

As exemplarily shown in Figs. 1a-d, the first clamping (anchoring) structures 24-1, 24-2 along the spaced perimeter regions 26-1, 26-2 and the (unclamped) spaced perimeter regions 27-1, 27-2 may comprise a straight course or shape, thereby providing a rectangular shape of the transducer element 12. However, other shapes or courses are also possible, for instance, the first clamping (anchoring) structures 24-1, 24-2 along the spaced perimeter regions 26-1, 26-2 and the (unclamped) spaced perimeter regions 26-1, 26-2 may also pairwise (for symmetry reasons) comprise a curved (e.g. convex or concave) or straight course or shape. For symmetry reasons, the first clamping structures 24-1, 24-2 may be equally spaced (equidistantly arranged) along the edge clamping regions (spaced perimeter regions) 26-1, 26-2. The edge clamping regions (spaced clamped perimeter regions) 26-1, 26-2 and the unclamped edge regions (unclamped spaced perimeter regions) 27-1, 27-2 may be equally spaced (equidistantly arranged) along the (lateral) perimeter or boundary of the transducer element 12.

Further, as shown in Figs. 1a-b, the second clamping (anchor) structures 36-1, 36-2 along the edge clamping regions 38-1, 38-2 may comprise a straight course or shape, thereby providing a rectangular shape of the elongation structure 32. However, other shapes or courses are also possible, for instance, the previously described first portions and/or second portions of the second clamping (anchoring) structures 36-1, 36-2 along the edge clamping regions (or spaced perimeter regions) 38-1, 38-2 may also pairwise (for symmetry reasons) comprise a curved (e.g. convex or concave) or straight course or shape. For symmetry reasons, the second clamping structures 36-1, 36-2 may be equally spaced (equidistantly arranged) along the edge clamping regions 38-1, 38-2.

According to the embodiment, the MEMS device 10, e.g. in form of a SDM microphone, with the semi-bridge or (one-sided) cantilever SDM design may achieve (at least) a higher compliance (flexibility) of the membrane arrangement having the mechanically coupled first and second deflectable membrane structures 14, 18 and the elongation structure 32 when compared to conventional SDM microphone of the same physical dimensions (footprint or chip size).

As exemplarily shown in Figs. 1a-b, the MEMS device 10 may have the following typical dimensions. The footprint (vertical projection) of the MEMS device 10 may have a first lateral dimension (= width along AA') between 0.5 and 2.0 mm and of about 1.2 mm and may have a second lateral dimension (= length along BB') between 0.5 and 2.0 mm and of about 1.7 mm. The deflectable membrane structures 14, 18 may have a first lateral dimension (= width along AA') between 0.3 and 1.8 mm and of about 0.7 mm. The rigid electrode 16 may have a first lateral dimension (= width along AA') between 0.3 and 1.8 mm and of about 0.7 mm. The deflectable membrane structures 14, 18 may have a second lateral dimension (length along BB') between 0.3 to 1.8 mm and of about 1.2 mm. The rigid electrode 16 may have a second lateral dimension (= length along BB') between 0.3 to 1.8 mm and of about 1.2 mm.

The deflectable membrane structures 14, 18 may be vertically spaced by a distance between 1 µm and 10.0 µm and about 4.0 µm and may have a thickness of about 0,2 to 1 µm, the rigid electrodes may have thickness of about 0,2 to 2 µm, and the vertical gap (spacing in a rest (= not-deflected) condition) between the opposing layers (rigid electrodes - deflectable membranes) may be about 0.5 to 5 µm. For instance, the vertical spacing between the deflectable membrane structures 14, 18 may be less than at least 1 µm, or at least 2.5 µm, or at least 5 µm, or at least 7.5 µm, or at least 10 µm. In other words, the vertical spacing between the deflectable membrane structures 14, 18 may be adapted to be less than sizes associated with particulate matter. For example, the vertical spacing between the deflectable membrane structures 14, 18 may be adapted to be less than sizes associated with PM_{2.5} (2.5 µm), or with PM₁₀ (10 µm). By this measure, particulate matter, such as PM_{2.5} and PM₁₀, may not be able to accumulate between the deflectable membrane structures 14, 18, and thereby prevent clogging (or blocking) of the deflectable membrane structures 14,18.

A first lateral extension, or width, w of the elongation structure 32 may range from 300 µm to 2000 µm. A second lateral extension, or length, of the elongation structure 32 may range from 300 µm to 2000 µm. For instance, as shown in Figs. 1a-b, the second lateral extension, or length, of the elongation structure 32 may be same as the second lateral dimension (= length along BB') of the transducer element 12.

The terms "electrode structure" and "membrane structure" are intended to illustrate that the membrane structures and the rigid electrode structure(s), respectively, can comprise a semi-conductive or conductive layer or, also, a layer sequence or layer stack having a plurality of different layers, wherein at least one of the layers is electrically conductive, e.g. a (highly-doped) conductive poly-silicon layer or a metallic layer.

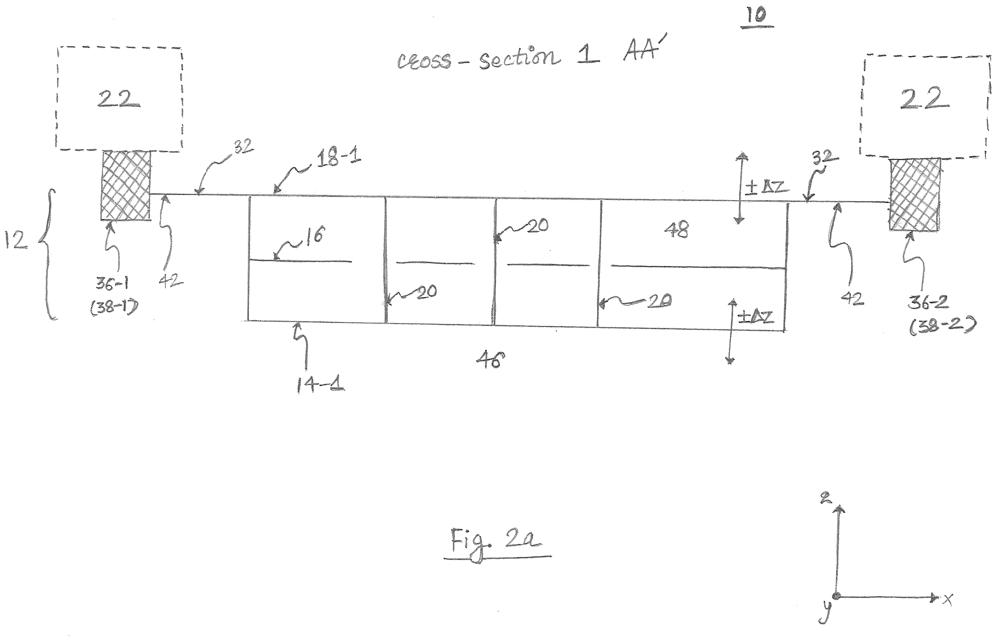

According to embodiments, and as exemplarily shown in Figs. 1a-c (and in Figs. 2a-d, 3a-b & 4a-d presented further), the (sound) transducer element 12 of the MEMS device 10 may have a microphone and/or loudspeaker functionality. Thus, the MEMS device 10 may be implemented as a MEMS microphone or MEMS loudspeaker, e.g. a sealed dual membrane (SDM) microphone or loudspeaker with a semi-bridge design.

Microphones are used for sensing or detecting ambient sound. Loudspeakers are used for emitting acoustic or ultrasonic sound to the environment. Thus, the sound transducer element 10 may be formed as a sensor (e.g., a microphone or pressure sensor) or as an actuator (e.g., a loudspeaker).

In case of an implementation of the sound transducer element 12 as a capacitive sensor, the deflection ±Δz of the membrane arrangement having the mechanically coupled first and second deflectable membrane structures 14, 18 is based on the applied external pressure load. The deflection or displacement ±Δz of the deflectable membrane arrangement can then be detected and capacitively read out, in order to provide a corresponding (analog or AD-converted digital) output signal of the sound transducer element 12. The deflection ±Δz of the deflectable membrane arrangement is (generally) caused by acoustically induced (sound) pressure changes in the environment.

According to a further embodiment, the sound transducer element 12 may also be implemented as an actuator, e.g., in form of a loudspeaker (due to its mode of operation) that uses the capacitive effect for generating sound. The initial mechanical motion of the deflectable membrane arrangement is created by applying a (modulated) voltage between the first and second deflectable membrane structures 14, 18, wherein this motion is typically converted into audible sound or ultrasonic sound.

According to embodiments, and as shown in Figs. 1c-d, the carrier element 22 (e.g. a substrate or a frame structure) may comprise a recess 46 (or, for example, an opening, or a void, or a cavity). The transducer element 12 and the elongation structure 32 may be arranged (e.g. attached) to cover the recess 46 in the carrier element 22. As can be seen in Figs. 1c-d, the deflectable portion 14-1 of the first deflectable membrane structure 18 may face the recess (or opening) 46 in the carrier element (substrate or frame structure) 22.

The recess (or opening) 46 in the carrier element 22 may have, in a vertical projection, essentially the same or a slightly laterally offset (enlarged) shape or course at the unclamped edge regions (or the unclamped spaced perimeter regions) 27-1, 27-2 of the transducer element 12 to allow the deflection ±Δz of the membrane arrangement having the mechanically coupled first and second deflectable membrane structures 14, 18 (= to allow the deflection ±Δz of the deflectable portions 14-1, 18-1 of the first and second deflectable membrane structure 14, 18 and of the elongation elements of the elongation structure 32).

According to embodiments, the rigid electrode structure 16 may be formed as a counter electrode (e.g. a perforated stator or a back-plate) with respect to the first and/or second deflectable membrane structure 14, 18.

Due to the semi-bridge design of the MEMS device 10, the rigid electrode structure 16 may be mechanically clamped at the edge clamping regions 26-1, 26-2 by means of the first clamping structures 24-1, 24-2 to the carrier element 22 and may mechanically decoupled from (deflectable with respect to) the carrier element 22 along the unclamped edge regions (or unclamped spaced perimeter regions) 27-1, 27-2. As the membrane arrangement 14, 18 of the transducer element 12, which has the mechanically coupled first and second deflectable membrane structures 14, 18, is, for example, arranged over the recess (or opening) 46 in the carrier element 22, the deflectable portions 14-1, 18-1 of the membrane arrangement 14, 18 of the transducer element 12 are mechanically decoupled (unclamped) from the carrier element 22 and, thus, displaceable (deflectable) with respect to the carrier element 22. Further, the elongation elements of the elongation structure 32 are also mechanically decoupled from the carrier element 22 and thus, also displaceable (deflectable) with respect to the carrier element 22.

Each clamping structure 24-1, 24-2 may comprise a first isolator element 24-A between the peripheral portions of the top membrane 14 and the stator 16, a second isolator element 24-B between the peripheral portions of the bottom membrane 18 and the stator 16, wherein the transducer element 12 is mechanically anchored by means of a third isolator element 24-C of the clamping structures 24-1, ..., 24-# to the carrier element 22. The different isolator elements (e.g. oxide elements or layers) 24-A, 24-B, 24-C of the clamping structures 24-1, ..., 24-# are provided to mechanically fix the border regions of the membranes 14, 18 and the stator 16 with respect to the carrier element 22.

Moreover, the transducer element 12 of the MEMS device 10 may comprise wall elements (pillar walls) 29-1, 29-2 at the unclamped edge regions (unclamped spaced perimeter regions) 34-1, 34-2, wherein along and laterally between the unclamped edge regions 34-1, 34-2, the transducer element 12 is mechanically decoupled (unclamped) from the carrier element 22 and, thus, displaceable (deflectable) with respect to the carrier element 22.

In accordance with embodiments, the mechanical connection elements 20, as depicted in Figs. 1c-d, may comprise a plurality of pillar-shaped or column-shaped mechanical connection elements between the two opposing deflectable membrane structures 14, 18.

The wall elements (pillar walls) 29-1, 29-2 may comprise the same material as the mechanical connection elements (pillars or columns) 20. Further, the wall elements (pillar walls) 29-1, 29-2 may comprise the same (lateral) thickness and (vertical) height as the mechanical connection elements 20. Thus, the wall elements (pillar walls) 29-1, 29-2 may be regarded in a vertical projection as line elements, while the mechanical connection elements may be regarded in a vertical projection as point elements.

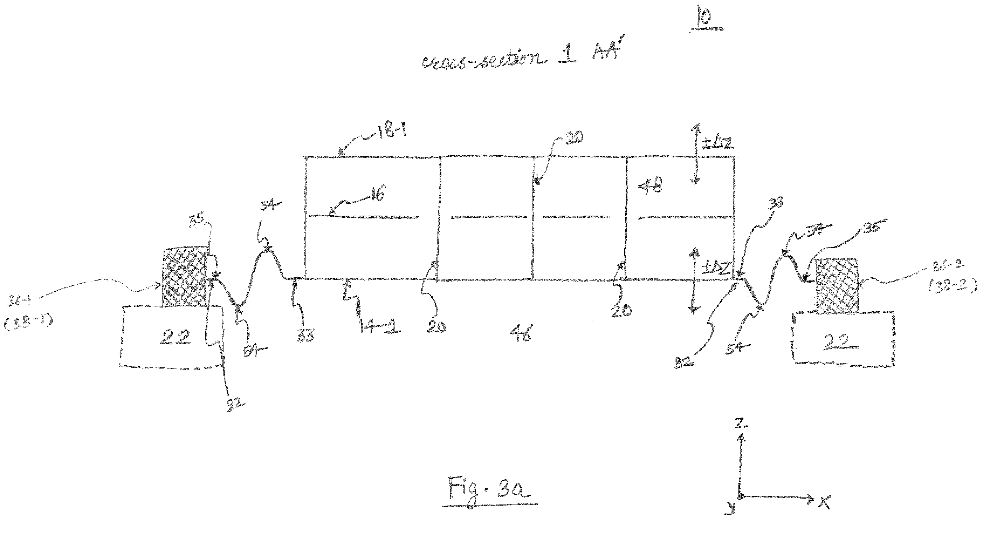

In accordance with embodiments, and as exemplarily shown in Figs. 1b (and in Figs. 2a-d, presented further), the MEMS device 10 further comprises a wall structure 44 at the unclamped edge regions 34-1, 34-2 of the transducer element 12. It should be noted that as per the oblique view of Fig. 1b, only one of the wall structure 44 at the unclamped edge region 34-1 of the transducer element 12 may be visible without excluding the presence of the other of the wall structure 44 at the unclamped edge region 34-2 of the transducer element 12. Further, as shown in Fig. 1b, the wall structure 44 may be arranged to span from an originating portion (not shown here in Fig. 1b but denoted in Figs. 3a-d presented further in the disclosure) of the elongation structure 32 (vertically) towards the second deflectable membrane structure 18. It is understandable that in other embodiments, the wall structure 44 may span towards the first deflectable membrane structure wherein the elongation structure extends at least partially in the same plane as the second deflectable membrane structure. Moreover, in further embodiments, wherein the elongation structure 32 may comprise the first 40 and the second 42 elongation elements extending (respectively) at least partially in the same plane as the first 14 and the second 18 deflectable membrane structure, the wall structure 44 may extend/span from a first originating portion of the first elongation element towards a second originating portion of the second elongation element and vice versa.

Dimensions of the wall structure 44 (at the unclamped edge regions 34-1, 34-2 of the transducer element 12) may be adapted so as to prevent passage, or continued passage resulting in an accumulation, of contaminants (or pollutants) such as particulate matter (e.g. PM_{2.5}, PM₁₀). For example, a vertical spacing (or vertical height) of the wall element 44 may be adapted to be same as the vertical spacing between the two deflectable membrane structures 14, 18. For example, the vertical spacing (or vertical height) of the wall element 44 may be less than at least 1 µm, or at least 2.5 µm, or at least 5 µm, or at least 7.5 µm, or at least 10 µm. By this measure, the MEMS device 10 may prevent passage, or accumulation, of particulates and allow the MEMS device 10 to be less prone towards (or less susceptible towards or more robust against) deterioration of its operational characteristics. This may further allow an increased durability of the MEMS device 10.

Further, in accordance with embodiments, the wall structure 44 (along with the first clamping structures 24-1, 24-2) and the first and the second deflectable membrane structures 14, 18 may together form a cavity 48 against the environment 50. The cavity 48 may be sealed against the environment 50.

As exemplarily depicted by way of dashed curved portions, the wall structure 44 may optionally comprise a single corrugated wall section 45, wherein the corrugated wall section 45, as shown in the oblique view of Fig. 1b, comprises a curved, round, sinusoidal or semicircular shape, which (laterally) extends in a direction into the cavity 48, i.e. the corrugated wall section 45 may be curved inwards or into the cavity 48. Alternatively, the corrugated wall section 45 may (laterally) extend in a direction outwards or away from the cavity 48, i.e. the corrugated wall section 45 may emerge or protrude (e.g. in a straight or curved manner) outwards or away from the cavity 48. Thus, the corrugated wall section 45 may form a lateral elongation (extension) of the wall structure 44.

The corrugated wall section 45 may have, in a vertical projection, the shape of a section of a circle, oval or ellipse, for example. Alternatively, the corrugated wall section 45 may have a straight, square, rectangular, triangle or sawtooth shape. Further, the wall structure 44 may comprise a plurality of corrugated wall sections 45-#. For example, the plurality of corrugated wall sections 45-# may be laterally spaced from each other by means of intermediate wall structures (spacers) along the unclamped edge regions 34-1, 34-2 of the transducer element 12.

According to an embodiment, the plurality of corrugated wall sections 45-# may comprise corrugated wall section which (laterally) extend (e.g. curve) inwards, or into, the cavity 48. According to a further embodiment, the plurality of corrugated wall sections 45-# may (laterally) extend (e.g. curve) outwards, or away, from the cavity 48. According to another embodiment, the plurality of corrugated wall sections 45-# may comprise a first set and a second set of corrugated wall sections 45-#, wherein the first set of the plurality of corrugated wall sections 45-# may (laterally) extend (e.g. curve) inwards, or into, the cavity 48 and the second set of the plurality of corrugated wall sections 45-# may (laterally) extend (e.g. curve) outwards, or away from, the cavity 48. For example, the first set and the second set of the plurality of the corrugated wall sections 45-# may together form an elongation of the wall structure 44 comprising an "S" shaped configuration.

The above described configurations of the wall structure 44 comprising the corrugated wall sections 45 may improve the compliance of the transducer element 12, and thus may contribute to the overall increased operational performance of the MEMS device 10.

According to embodiments, the sealed cavity 48 may comprises a low pressure region. The low pressure region, which is located within the sealed cavity 48, may comprise a reduced atmospheric pressure when compared to the environmental atmosphere, wherein, for example, the reduced atmospheric pressure in the low pressure region may be vacuum or near to vacuum.

The low pressure region may have an atmospheric pressure that may be less than an ambient pressure or a standard atmospheric pressure. To be more specific, according to an embodiment, the pressure in the low pressure region may be substantially a vacuum or a near-vacuum. Alternatively, the pressure in the low pressure region may be less than about 50% (or 40%, 25%, 10% or 1%) of the ambient pressure or the standard atmospheric pressure. The standard atmospheric pressure may be typically 101.325 kPa or 1013.25 mbar. The pressure in the low pressure region may also be expressed as an absolute pressure, for example less than 50, 40, 30 or less than 10 kPa.

As exemplarily shown in Figs. 1a-c (and in Figs. 2a-d, presented further), the transducer element 12 of the MEMS device 10 may have straight (e.g. or slightly curved; or slightly concave or slightly convex) wall elements (pillar wall) 29-1, 29-2.

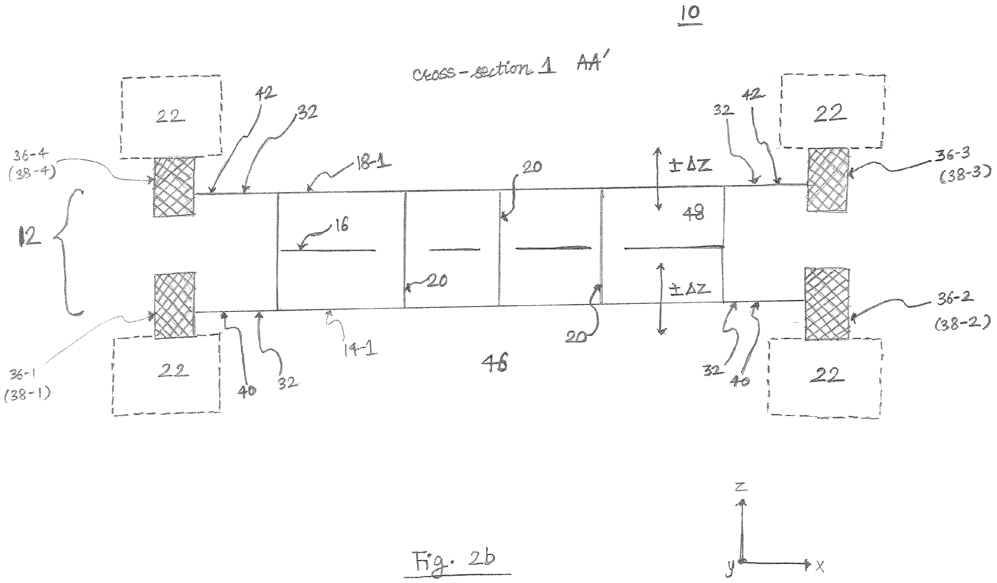

In the following, Figs. 2a-b present two further embodiments relating to exemplary arrangements of the elongation structure 32 to the transducer element 12. While the embodiment presented in Fig. 2a provides an alternative to the embodiment described in Figs. 1b-d, the embodiment in Fig. 2b can be obtained/arrived at by a combination of the former with the latter.

Figs. 2a exemplarily shows a schematic cross sectional view (parallel to the x-z-plane) along a sectional line AA' (= cross-sectional plane 1) of an exemplary MEMS device 10. In accordance with embodiments, and as shown in Fig. 2a, the elongation structure 32 comprises second elongation elements 42 which extend, at least partially in the same plane as the second deflectable membrane structure 18, from the transducer element 12 to the second clamping structures 36-1, 36-2. In accordance with embodiments, for instance, the second elongation elements 42 could extend, being entirely in the same plane as the second deflectable membrane structure 18, from the transducer element 12 to the second clamping structures 36-1, 36-2.

It is emphasized that the embodiment presented in Fig. 1a-d wherein the (first) elongation elements 40 of the elongation structure 32 extend at least partially, or entirely, in the same plane as the first deflectable membrane structure 14 and the embodiment presented in Fig. 2a wherein the (second) elongation elements 42 of the elongation structure 32 extend at least partially, or entirely, in the same plane as the second deflectable membrane structure 18 disclose two possibilities (with equal preference to both) of arrangements of the elongation structure 32 to the deflectable membrane structures 14, 18 of the transducer element 12, in accordance with the the present invention.

Fig. 2b exemplarily shows a schematic cross-sectional view (parallel to the x-z plane) along a sectional line AA' (= cross-sectional plane 1) of another exemplary MEMS device 10 also in accordance with embodiments. As shown in Fig. 2b, in accordance with embodiments, the elongation structure 32 may comprise first elongation elements 40 and second elongation elements 42, wherein the first elongation elements 40 extend at least partially, or possibly entirely, in the same plane as the first deflectable structure 14 from the transducer element 12 to the second clamping structures 38-1, 38-2 (at the edge clamping regions 38-1, 38-2) and the second elongation elements 42 extend at least partially, or possibly entirely, in the same plane as the second deflectable membrane structure 18 from the transducer element 12 to the second clamping structures 38-3, 38-4 (at the edge clamping regions 38-3, 38-4).

Further, in accordance with embodiments and with Figs. 2a-b, the second elongation elements 42 of the elongation structure 32 may be formed as lateral elongations of the second deflectable membrane structure 18. These lateral elongations may extend from the unclamped edge regions 34-1, 34-2 of the transducer element 12 towards the respective second clamping structures 36-# and may further be mechanically decoupled from the carrier element 22 and, thus, may be displaceable (deflectable) with respect to the carrier element 22.

In the following, Figs. 3a-d present two further embodiments relating to exemplary implementations of the elongation structure 32 to the transducer element 12, wherein the elongation structure 32 comprises stress relief structures such as a corrugation element or or a slit/through-hole.

Fig. 3a exemplarily shows a schematic cross-sectional view (parallel to the x-z plane) along a sectional line AA' (= cross-sectional plane 1) of an exemplary MEMS device 10. The MEMS device 10 depicted in Fig. 3a may be considered as a variation of the exemplary MEMS device 10 depicted in Fig. 1c. Specifically, in accordance with embodiments and with Fig. 3a, the elongation structure 32 comprises corrugation elements 54 (e.g. as stress-relief structure), wherein the corrugation elements 54 (laterally) extend parallel to the second clamping structures 36-1, 36-2.

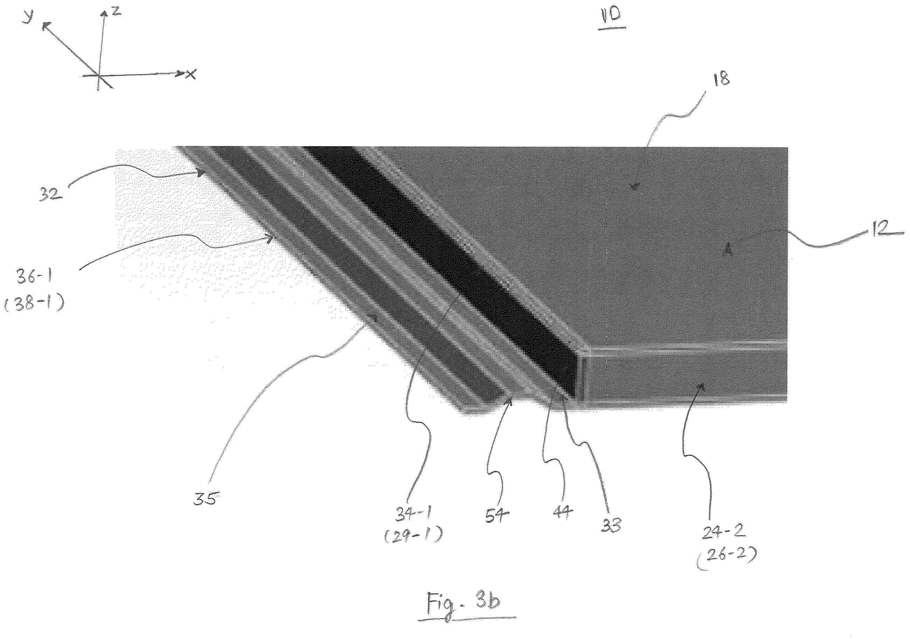

Fig. 3b exemplarily shows an oblique cross-sectional partial view (oblique to the x-y plane) of an exemplary MEMS device 10. In contrast to Fig. 3a, the elongation structure 32 comprises a single corrugation element 54 (laterally) extending parallel to the second clamping structure 36-1.

It is depicted in Fig. 3b, in accordance with embodiments and with Fig. 3a, that an originating portion 33 and a terminating portion 35 of the elongation structure 32 are in the same plane as the first deflectable membrane structure 14. Additionally or alternatively, the originating portion 33 and the terminating portion 35 of the elongation structure 32 could be in the same plane as the second deflectable membrane structure 18.

The oblique view presented in Fig. 3b and the cross-sectional view in Fig. 3a clearly indicate that the corrugation element(s) 54 may extend (vertically) in a direction into the cavity 46 and/or a direction away from the cavity 46. Further, the corrugation element(s) 54 may comprise a curved, round, sinusoidal or semicircular shape.

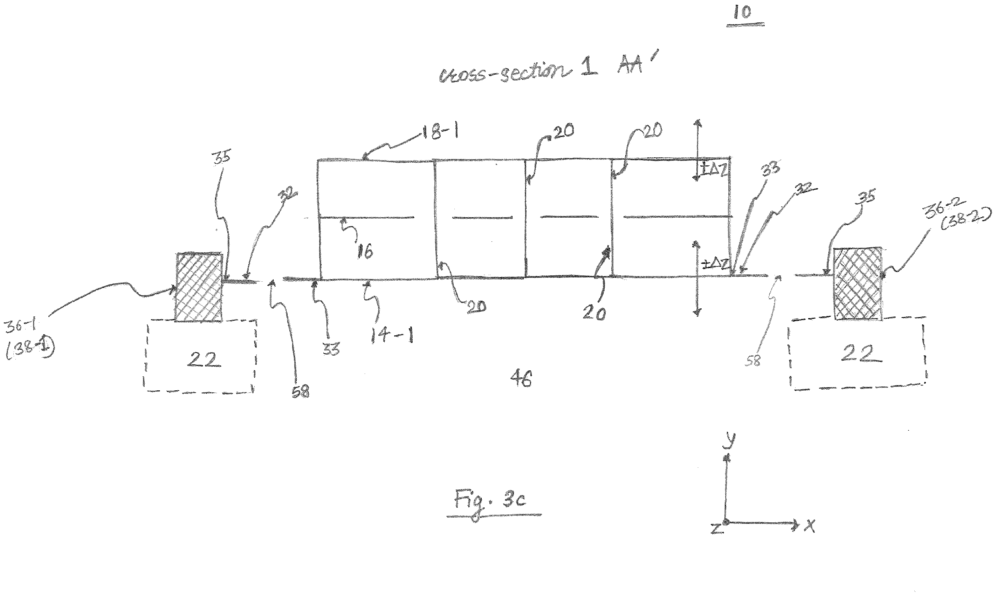

Fig. 3c exemplarily shows a schematic cross-sectional view (parallel to the x-y plane) along a sectional line AA' of an exemplary MEMS device 10. As clearly shown in Fig. 3c, the elongation structure 32 comprises a slit or through-hole 58.

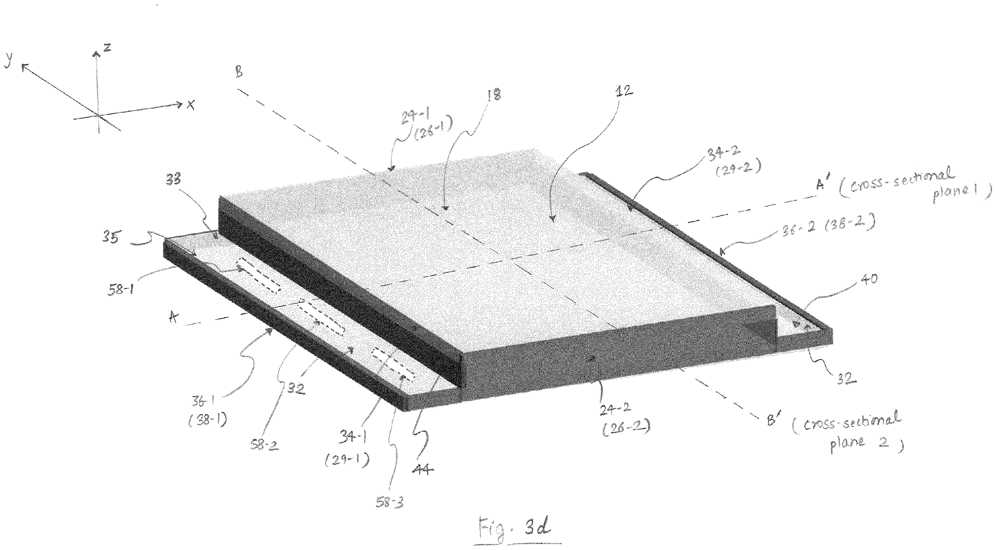

Fig. 3d exemplarily shows an oblique cross-sectional view (oblique to the x-y plane) of an exemplary MEMS device 10. As clearly shown in Fig. 3d, the elongation structure 32 comprises a plurality of slits or through-holes 58-1, 58-2, 58-3. The slits/through-holes 58-1, 58-2, 58-3, as shown in Fig. 3d, may be arranged to be parallel to the wall structure 44 at the unclamped edge region 34-1 of the transducer element 12. For instance, size (lateral extensions) of the slits or though-holes may be adapted to prevent blocking by particulate matter, in other words, the slits or though-holes may be too small for allowing a passage of contaminants such as particulate matter.

The slits or through-holes 58-# allow a lateral air exchange for equalizing (as a low pass functionality) slow (static, e.g. temperature dependent) environmental pressure changes between the substrate/carrier element 22 and the elongation structure 32 of the sound transducer element 12. Further, the slits or through holes 58-# may not only comprise a straight course or shape, as shown in Figs. 3c-d, but may comprise a curved course or shape.

Hitherto the present disclosure provides schematic cross-sectional view(s) (parallel to the x-y plane) along the sectional line AA' (= cross-sectional plane 1) of different MEMS devices 10 in Figs. 2a & 3a-d. These cross-sectional view(s) are accompanied with a corresponding schematic cross-sectional view (parallel to the y-z plane) of the corresponding exemplary MEMS device 10 along the sectional line BB' (= cross-sectional plane 2), as already depicted in Fig. 1d.

In the following, also referring to already described Figs. 1a-d, 2a-b & 3a-d, different embodiments of the MEMS device 10 with respect to the implementation as a MEMS microphone or MEMS loudspeaker, e.g. a sealed dual membrane (SDM) microphone or loudspeaker with a semi-bridge design are described. The described semi-bridge design of the MEMS device 10 (owing to the elongation structure 32) improves the compliance and, thus, the mechanical sensitivity of the membrane arrangement having the mechanically coupled first and second deflectable membrane structures 14, 18 and, hence, the overall operational performance of the MEMS device in form of a MEMS microphone or MEMS loudspeaker, e.g. a sealed dual membrane (SDM) microphone or loudspeaker.

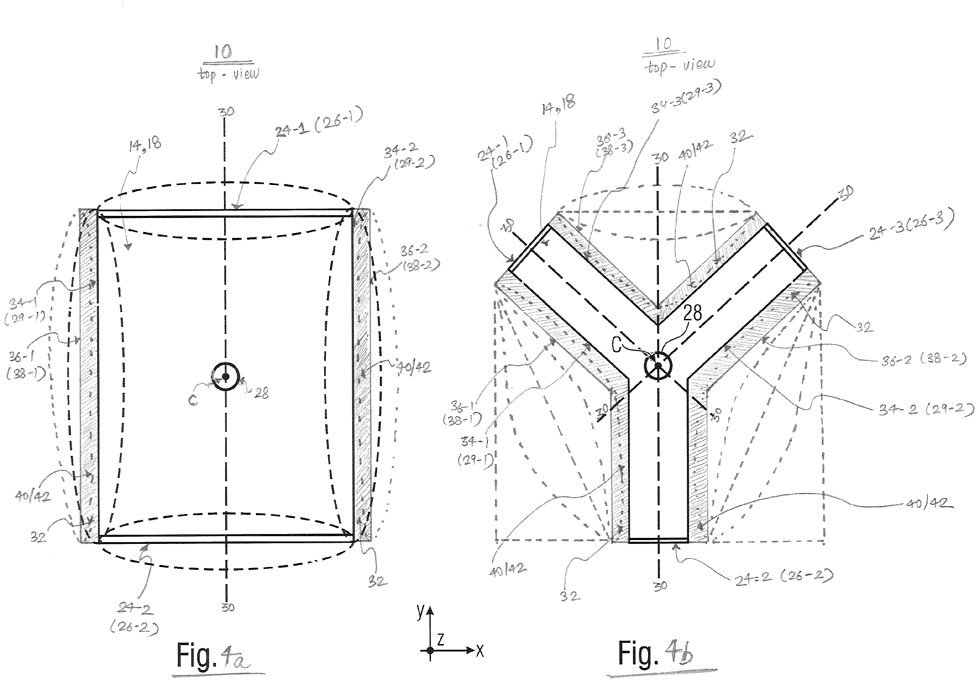

Figs. 4a-d show schematic top (plane) views of the MEMS device 10 with further exemplary implementations of the semi-bridge or (multiple) semi-cantilever design of the MEMS device 10, e.g. in form of a SDM sound transducer (microphone or loudspeaker), in accordance with further embodiments of the present disclosure.

As exemplarily shown in Fig. 4a, the (sound) transducer element 12 having the membrane arrangement having the mechanically coupled first and second deflectable membrane structures 14, 18 may comprise a rectangular shape (in the lateral plane).

The first clamping (anchoring) structures 24-1, 24-2 along the edge clamping regions (or spaced clamping/perimeter regions) 26-1, 26-2 and the elongation structure 32 extending along the unclamped edge regions (or unclamped spaced perimeter regions) 34-1, 34-2 may comprise a straight course or shape resulting in a rectangular (lateral) shape of the footprint (base area) of the (sound) transducer element 12 (see the continuous line of Fig. 4a). However, the first clamping (anchoring) structures 24-1, 24-2 along the edge clamping regions 26-1, 26-2 and the elongation structure 32 along the unclamped edge regions 34-1, 34-2 may also pairwise (for symmetry reasons) comprise a convex, concave or straight course or shape (see also the dashed lines of Fig. 4a indicating the possible shapes of the first clamping structures).

Thus, the MEMS device 10 of Fig. 4a comprises semi-bridge design, which can also be regarded as a "two-arm" configuration, wherein the two arms extending form a geometrical center region (or center point) 28 of the transducer element 12.

Thus, as exemplarily shown in Fig. 4a, the MEMS device 10 may comprise a transducer element 12, which may have a polygonal shape with an even number of sides, or edges. The shape of the transducer element 12 further may be a simple convex polygon. As exemplarily illustrated in Fig. 4a, the transducer element 12 may be clamped, or mechanically anchored, to the carrier element (or substrate) 22 along two opposite sides, or edges, 26-1, 26-2 and the elongation structure 32 may be clamped, or mechanically connected (or anchored), to the carrier element (or substrate) 22 extending away from two opposite sides, or edges, 34-1, 34-2.

As exemplarily shown in Figs. 4b-d, the (sound) transducer element 12 having the membrane arrangement with the mechanically coupled first and second deflectable membrane structures 14, 18 and the elongation structure 32 together may comprise a multiple-arm configuration.

Fig. 4b exemplarily shows a three-arm configuration, wherein the transducer element 12 may be clamped or mechanically anchored to the carrier element (or substrate) 22 along three edges/sides with three first clamping (or anchoring) structures 24-1, 24-2, 24-3 along the spaced perimeter regions 26-1, 26-2, 26-3 and the elongation structure 32, extending away from the unclamped edge regions 34-1, 24-2, 34-3, may be clamped or mechanically connected (or anchored) to the carrier element (or substrate) 22 by the second clamping structures 36-1, 36-2, 36-3.

The exemplarily configuration of Fig. 4b may also apply to any odd number, 2N+1 with N = 1, 2, 3, 4, ..., of arms, wherein the first clamping (anchoring) structures 24-1, ... , 24-# (here: # = 2N+1) along the edge clamping regions (or spaced perimeter regions) 26-1,..., 26-# may also (e.g. all regions for symmetry reasons) comprise a convex, concave or straight course or shape, and wherein the second clamping (anchoring) structures 36-1, ..., 36-# (here: # = 2N+1) along the elongation structure 32 extending away from the unclamped edge regions (or unclamped spaced perimeter regions) 34-1, ... , 34-# (# = 2N+1) may also (e.g. at least pairwise or all regions for symmetry reasons) comprise a convex, concave or straight course or shape.

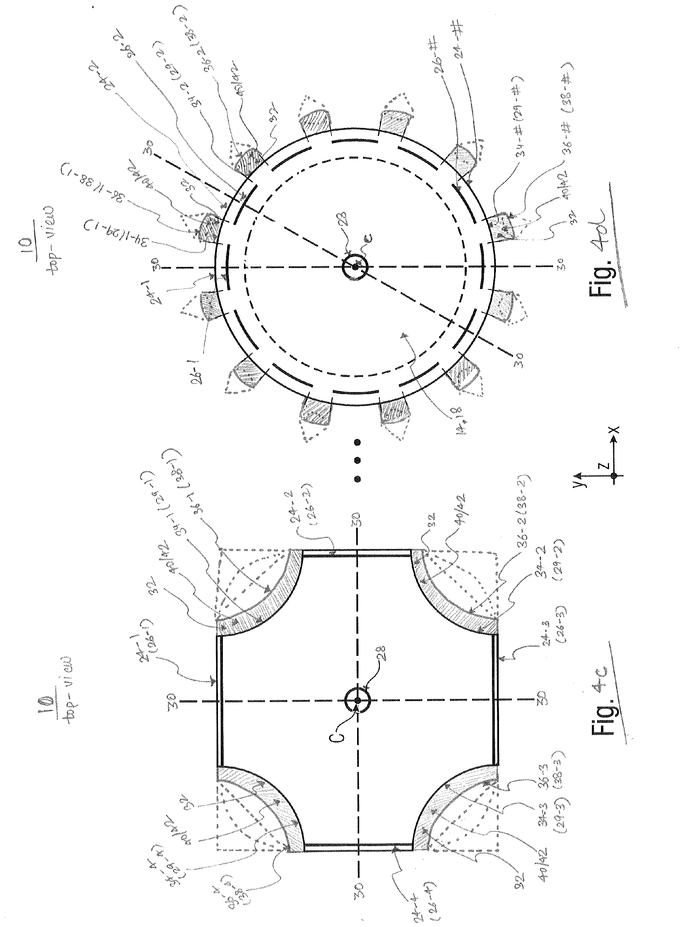

Fig. 4c exemplarily shows a four-arm configuration, wherein the transducer element 12 may be clamped or mechanically anchored to the carrier element (or substrate) 22 along four sides with four clamping or anchoring structures 24-1, 24-2, 24-3, 24-4 along the spaced perimeter regions 26-1, 26-2, 26-3, 26-4 and the elongation structure 32, extending away from the unclamped edge regions 34-1, 24-2, 34-3, 34-4, may be clamped or mechanically connected (or anchored) to the carrier element (or substrate) 22 by the second clamping structures 36-1, 36-2, 36-3, 36-4.

The exemplarily configuration of Fig. 4c may also apply to any even number, 2N with N = 2, 3, 4, ..., of arms, wherein the first clamping (or anchoring) structures 24-1, ..., 24-# (here: # = 2N) along the edge clamping regions (or spaced perimeter regions) 26-1,..., 26-# and wherein the second clamping (or anchoring) structures 36-1, ..., 36-# (# = 2N) along the elongation structure 32 extending away from the unclamped edge regions (or unclamped spaced perimeter regions) 34-1, ..., 34-# (# = 2N) may also may also (e.g. at least pairwise or all regions for symmetry reasons) comprise a convex, concave or straight course or shape.

Fig. 4d exemplarily shows a round (e.g. circular, oval or elliptic) configuration of the (sound) transducer element 12, wherein the transducer element 12 may be clamped or mechanically anchored to the carrier element (or substrate) 22 along a plurality of (e.g. at least four) first perimeter segments with the first clamping (or anchoring) structures 24-1, ... , 24-# along the (e.g. at least four) edge clamping regions (or spaced perimeter regions) 26-1, ..., 26-# and wherein the elongation structure 32, extending away from the unclamped edge regions 34-1, ..., 34-#, may be clamped or mechanically coupled (or anchored) to the carrier element (or substrate) 22 along a plurality of (e.g. at least four) second perimeter segments with the second clamping (or anchoring) structures 36-1, ..., 36-#.

Figs. 4a-d also exemplarily show using dashed lines associated with the elongation structure 32 that the elongation structure 32 may comprise different course or shapes (or e.g. footprint). For example, the elongation structure 32 may comprise a straight or a curved (e.g. convex or concave) shape. Further, the elongation structure 32 may partially comprise a straight course or shape and may partially comprise a curved course or shape (e.g. concave or convex shape). These different courses or shape may be chosen as desired or adapted according to preferences. Additionally, or alternatively, these different courses or shape could be a result (or, e.g. due to an effect) of an associated manufacturing process or manufacturing step. Therefore, it is possible that embodiments may comprise asymmetric courses or shapes of the elongation structure 32, which may be due to a desired choice (or a preference) and/or may be a result (or artefact) of the associated manufacturing process or manufacturing step.

The elongation structure 32 has been depicted in Figs. 4a-d as comprising the first elongation elements 40 and/or the second elongation elements 42 (as indicated specifically by the reference signs 40/42 in Figs. 4a-d). This means that each of the Figs. 4a-d relate therein to at least three different configurations (without preferring one over another) - a first wherein the elongation structure 32 may comprise only the first elongation elements 40, a second wherein the elongation structure 32 may comprise only the second elongation elements 42 and a third wherein the elongation structure 32 may comprise both the elongation elements 40, 42.

The transducer element 12 may comprise a number of shapes, wherein the list of shapes of the transducer element 12, exemplarily shown in Figs. 1a, 3d and Figs. 4a-d may not be regarded as exhaustive, wherein the below described additional geometrical and structural implementations and configurations of the MEMS device 10 may further contribute to the improvement of the compliance of the membrane arrangement of the (sound) transducer element 12 having the mechanically coupled first and second deflectable membrane structures 14, 18.

According to embodiments, as exemplarily shown in Figs. 1a,b, 3d and 4a-d, an overall combined length of the first clamping structures 24-1, ..., 24-# (e.g. meaning length of each clamping structure 24-# is combined to form the overall combined length) along the perimeter (e.g. boundary, or lateral perimeter/boundary; e.g. perimeter in a plane parallel to the main surface region of the carrier element/substrate 22) of the transducer element 12 may be equal or less than (≤) 50 % of the (overall) perimeter length L (or overall boundary length) of the transducer element 12. Further, for each of the edge clamping regions (or spaced clamping regions/spaced perimeter regions) 26-1, ..., 26-#, a lateral bisecting line 30 bisecting the respective edge clamping region(s) 26-# may pass through a geometrical center region (or point) (or lateral geometrical center region/point) 28 of the transducer element. A number of (i.e. a count of) the lateral bisecting lines 30 bisecting the respective edge clamping region(s) 26-# may depend on a shape, or symmetry (e.g. a number of "arms") of the transducer element 12. For instance, the transducer element 12 having an odd number of "arms", as depicted in Fig. 4b, may have an odd number of lateral bisecting lines 30 bisecting the edge clamping region 26-1, ..., 26-N (N=3 for Fig. 4b), and the transducer element 12 having an even number of "arms", as depicted in Fig. 4b, may have an even number of lateral bisecting lines 30 bisecting the edge clamping region 26-1, ..., 26-N (N=2 for Fig. 4a, N=4 for Fig. 4c). Further, for instance, each lateral bisecting lines 30 may also (laterally) bisect the transducer element 12, as depicted in Figs. 4a-d.

Further, according to embodiments, as exemplarily shown in Figs. 1a,b, 3a,d & 4a-d, an overall combined length of the second clamping structures 36-1, ..., 36-# (e.g. meaning length of each clamping structure 24-# is combined to form the overall combined length) along the perimeter (e.g. boundary, or lateral perimeter/boundary; e.g. perimeter in a plane parallel to the main surface region of the carrier element/substrate 22) of the elongation structure 32 may be equal or less than (≤) 50 % of the (overall) perimeter length L (or overall boundary length) of the transducer element 12.

According to embodiments, the (lateral) geometrical center region 28 may have a lateral extension around the (lateral) geometric center point "C" of the transducer element 12 which may be less than 1 %, 3% or 5 % of an overall first lateral extension (or lateral diameter) "D" of the transducer element 12.

According to embodiments, as exemplarily shown in Figs. 1a-c and 4a-d, the edge clamping regions 26-1, ..., 26-# may be equally spaced (equidistantly arranged) along the (lateral) perimeter of the transducer element 12. The unclamped edge regions (or unclamped spaced perimeter regions) 27-1, ..., 27-# are arranged along the (lateral) perimeter of the transducer element 12 between the equally spaced edge clamping regions 26-1, ..., 26-#.

According to embodiments, as exemplarily shown in Figs. 1a-c and 4a, 4c, 4d, the plurality of first clamping structures 24-1, ..., 24-# may comprise 2N first clamping structures, with N = 1, 2, 3, 4, ..., wherein the respective lateral bisecting line 30 passes through two opposing edge clamping regions (spaced perimeter regions) 26-1, 26-2, ..., 26-# and the geometrical center region 28 of the transducer element 12.

According to embodiments, as exemplarily shown in Fig. 4b, the plurality of first clamping structures 24-1, ..., 24-# may comprise 2N+1 first clamping structures, with N = 1, 2, 3, 4, ..., wherein each lateral bisecting line (or equivalently lateral axis of symmetry) of the transducer element 12 passes through a first clamping structure 24-1, ..., 24-# and the geometrical center region 28 of the transducer element 12.

According to embodiments, the plurality of (pillar-shaped or column-shaped) mechanical connection elements 20, as depicted in Figs. 1c-d, 2a-b, 3a, 3c may be non-conductive, for example, in order to realize the first and second membrane structures 14, 18 as two electrically separated electrodes for a differential (read-out) operation, i.e. to allow a differential read out configuration of the first and second membrane structures 14, 18. Thus, the pillars can be made at least partially of an insulating material, wherein the pillars 20 can be made of an insulating material, like silicon, nitride, silicon oxide, a polymer or a combination of the former materials, or a combination of the former materials with a conductive layer (for instance silicon), provided the conductive part of the pillars is separated from the membrane structures 14, 18 by an insulating material.

According to further embodiments, the plurality of (pillar-shaped or column-shaped) mechanical connection elements 20 may be conductive, for example, in order to realize an electrical connection of the first and second membrane structures 14, 18 as two electrically connected electrodes.

To summarize, a (sealed) dual or multiple MEMS microphone 10 with a (vacuum) cavity 48 relies on a number of mechanically connection elements, also referred to as pillars or columns, 20, which are connecting both membrane structures 14, 18 (in case of a dual membrane arrangement), and prevent the membrane structures 14, 18 from collapsing because of the pressure loads on both membrane structures 14, 18, i.e., the external pressure onto the top of the top membrane structure 14 and the external pressure onto the bottom of the bottom membrane structure 18.

The mechanical connection elements 20 of a dual-membrane MEMS microphone 10 are equally applicable to a multiple-membrane MEMS microphone 10 having three or more membrane structures, wherein neighboring membrane structures are mechanically coupled by means of mechanical connection elements 20. In case, the MEMS device 10 is formed as a multiple-membrane MEMS microphone having three membrane structures, the MEMS device 10 may comprise a first and second rigid electrode structure and a first to third deflectable membrane structure in a vertically spaced configuration, e.g. in vertically separated and spaced configuration. The first rigid electrode structure is sandwiched between the first and second deflectable membrane structure, wherein the second rigid electrode structure is sandwiched between the second and third deflectable membrane structure. The first, second and third deflectable membrane structures each comprises a deflectable portion, wherein the deflectable portions of the first, second and third deflectable membrane structures are mechanically coupled to each other by means of the mechanical connection elements 20, and are mechanically decoupled from the first and second rigid electrode structures. This setting of the MEMS device 10 can be also applied to a multiple-membrane MEMS microphone having four or more membrane structures.

As exemplarily shown in Figs. 1a-d, 2a-b, 3a-d and 4a-d, the transducer element is depicted in its rest position, e.g. when no sound wave arrives at the deflectable membrane structures. An incident sound wave may cause the deflectable portion of the membrane structures 14-1, 18-1 to deflect. Further, the two deflectable membrane structures 14-1, 18-1 may be exposed to an ambient pressure and potentially a sound pressure. The top side of the first deflectable membrane structure 14-1 may also be regarded as a sound receiving main surface of the MEMS device 10. Additionally, the bottom side of the second deflectable membrane structure 18 may also be regarded as a sound receiving main surface of the MEMS device 10. When sound waves are incident on the membrane structures 14, 18, the membrane structures 14, 18 may deflect or oscillate. A displacement of one membrane (either of the two membrane structures 14-1. 18-1) may result in the corresponding displacement of the second membrane and vice versa. It is to be noted that in accordance with a plurality of embodiments, the membrane structures 14-1, 18-1 may be deflected in response to a change in pressure caused by an incident sound wave. Electrical signals may be generated by the deflection of the membrane structures 14-1, 18-1 and might be read out by a plurality of read-out circuits. The read-out circuits may process the electrical signals and may finally convert the electrical signals into useable information, as a possible last step of signal processing.

Figs. 4a-d show different exemplary schematic top (plane) view of the MEMS device 10 along with some possible implementations for the improvement of mechanical compliance or mechanical sensitivity. The shape of the transducer element 12 and the elongation structure 32 may be chosen or optimized for various targets and combinations thereof, e.g., chip size, capacitance, motor sensitivity, resonance frequency, etc. In particular, the shape and design of the transducer element 12 and the elongation structure 32 may even be optimized such that the mechanical compliance requirement may be achieved. Thus, the transducer element 12 and the elongation structure 32 may comprise a number of shapes, wherein the list of shapes of the transducer element 12 and the elongation structure 32 may not be regarded as exhaustive.

Further, Figs. 4a-d illustrate that the plurality of first clamping, or mechanically anchored, structures 24-1, 24-2... 24-# spaced along the edge clamping regions/perimeter regions (clamping regions) 26-1, 26-2, ..., 26-# of the transducer element 12 may be supported by means of the carrier element (or substrate) 22. The number of such regions along which the transducer element 12 may be clamped to the substrate 22 may be, at least two or more. According to further embodiments, the lateral bisecting lines 30 bisecting the spaced perimeter regions (clamping regions) 26-1, 26-2 ... 26-# may coincide with the (lateral) axis (or axes) of symmetry of the transducer element 12.

Figs. 4a-d also illustrate that the the plurality of second clamping, or mechanically anchored, structures 36-1, 36-2... 36-# spaced along the edge clamping regions/perimeter regions (clamping regions) 38-1, 38-2, ..., 38-# of the elongation structure 32 may be supported by means of the carrier element (or substrate) 22. The number of such regions along which the elongation structure 32 may be clamped to the substrate 22 may be, at least two or more.

Additional embodiments and aspects are described which may be used alone or in combination with the features and functionalities described herein.

According to embodiments, a MEMS device comprises: a transducer element having a first deflectable membrane structure, a rigid electrode structure and a second deflectable membrane structure in a vertically spaced configuration, wherein the rigid electrode structure is arranged between the first and second deflectable membrane structure, the first and second deflectable membrane structure each comprise a deflectable portion, and wherein the deflectable portion of the first deflectable membrane structure and the deflectable portion of the second deflectable membrane structure are mechanically coupled by means of mechanical connection elements to each other and are mechanically decoupled from the rigid electrode structure; a carrier element for supporting the transducer element; a plurality of first clamping structures for mechanically connecting the transducer element to the carrier element at edge clamping regions of the transducer element; an elongation structure laterally extending from unclamped edge regions of the transducer element; a plurality of second clamping structures for mechanically connecting the elongation structure to the carrier element at edge clamping regions of the elongation structure; and wherein the elongation structure comprises first elongation elements which extend at least partially in the same plane as the first deflectable membrane structure from the transducer element to the second clamping structures, or wherein the elongation structure comprises second elongation elements which extend at least partially in the same plane as the second deflectable membrane structure from the transducer element to the second clamping structures.

According to embodiments, wherein the elongation structure comprises first elongation elements which extend at least partially in the same plane as the first deflectable membrane structure from the transducer element to the second clamping structures, and wherein the elongation structure comprises second elongation elements which extend at least partially in the same plane as the second deflectable membrane structure from the transducer element to the second clamping structures.

According to embodiments, wherein an originating portion and a terminating portion of the elongation structure are in the same plane as the first deflectable membrane structure and/or wherein an originating portion and a terminating portion of the elongation structure are in the same plane as the second deflectable membrane structure.

According to embodiments, wherein the transducer element is mechanically decoupled from the carrier element at the unclamped edge regions.

According to embodiments, wherein the elongation structure comprises a corrugation element extending parallel to the second clamping structures.

According to embodiments, wherein the elongation structure comprises a slit or through-hole.

According to embodiments, wherein the first elongation elements are formed as lateral elongations of the first deflectable membrane structure and

According to embodiments, wherein the second elongation elements are formed as lateral elongations of the second deflectable membrane structure.

According to embodiments, wherein the edge clamping regions of the transducer element and the edge clamping regions of the elongation structure are arranged in an alternating order.

According to embodiments, wherein the carrier element comprises a recess and wherein the transducer element and the elongation structure are arranged to cover the recess in the carrier element.

According to embodiments, the MEMS device further comprises a wall structure at the unclamped edge regions of the transducer element.

According to embodiments, wherein the first and the second deflectable membrane structures and the wall structure together form a cavity against the environment, wherein the cavity is sealed against the environment and the cavity comprises a low pressure region, wherein the low pressure region comprises a reduced atmospheric pressure when compared to the environmental atmosphere.

According to embodiments, wherein the mechanical connection elements comprise a plurality of pillar-shaped or a column-shaped mechanical connection elements between the two opposing deflectable membrane structures.

According to embodiments, wherein the rigid electrode structure forms a counter-electrode with respect to the first and/or second deflectable membrane structure.

According to embodiments, wherein the transducer element has a microphone and/or loudspeaker functionality.

Although some aspects have been described as features in the context of an apparatus, it is clear that such a description may also be regarded as a description of corresponding features of a method. Although some aspects have been described as features in the context of a method, it is clear that such a description may also be regarded as a description of corresponding features concerning the functionality of an apparatus.

Depending on certain implementation requirements, embodiments of the control circuitry can be implemented in hardware or in software or at least partially in hardware or at least partially in software. Generally, embodiments of the control circuitry can be implemented as a computer program product with a program code, the program code being operative for performing one of the methods when the computer program product runs on a computer. The program code may, for example, be stored on a machine-readable carrier.

In the foregoing detailed description, it can be seen that various features are grouped together in examples for the purpose of streamlining the disclosure. This method of disclosure is not to be interpreted as reflecting an intention that the claimed examples require more features than are expressly recited in each claim. Rather, as the following claims reflect, subject matter may lie in less than all features of a single disclosed example. Thus, the following claims are hereby incorporated into the detailed description, where each claim may stand on its own as a separate example. While each claim may stand on its own as a separate example, it is to be noted that, although a dependent claim may refer in the claims to a specific combination with one or more other claims, other examples may also include a combination of the dependent claim with the subject matter of each other dependent claim or a combination of each feature with other dependent or independent claims. Such combinations are proposed herein unless it is stated that a specific combination is not intended. Furthermore, it is intended to include also features of a claim to any other independent claim even if this claim is not directly made dependent to the independent claim.

Although specific embodiments have been illustrated and described herein, it will be appreciated by those of ordinary skill in the art that a variety of alternate and/or equivalent implementations may be substituted for the specific embodiments shown and described without departing from the scope of the present embodiments. This application is intended to cover any adaptations or variations of the specific embodiments discussed herein. Therefore, it is intended that the embodiments be limited only by the claims and the equivalents thereof.

## Claims

1. MEMS device (10) comprising:
a transducer element (12) having a first deflectable membrane structure (14), a rigid electrode structure (16) and a second deflectable membrane structure (18) in a vertically spaced configuration,
wherein the rigid electrode structure (16) is arranged between the first and second deflectable membrane structure (14, 18), the first and second deflectable membrane structure (14, 18) each comprise a deflectable portion (14-1, 18-1), and wherein the deflectable portion (14-1) of the first deflectable membrane structure (14) and the deflectable portion (18-1) of the second deflectable structure (18) are mechanically coupled by means of mechanical connection elements (20) to each other and are mechanically decoupled from the rigid electrode structure (16);
a carrier element (22) for supporting the transducer element (12);
a plurality of first clamping structures (24-1, ..., 24-#) for mechanically connecting the transducer element (12) to the carrier element (22) at edge clamping regions (26-1, ..., 26-#) of the transducer element (12);
an elongation structure (32) laterally extending from unclamped edge regions (34-1, ..., 34-#) of the transducer element (12);
a plurality of second clamping structures (36-1, ..., 36-#) for mechanically connecting the elongation structure (30) to the carrier element (22) at edge clamping regions (38-1, ..., 38-#) of the elongation structure (32); and
wherein the elongation structure (32) comprises first elongation elements (40) which extend at least partially in the same plane as the first deflectable membrane structure (14) from the transducer element (12) to the second clamping structures (36-1, ..., 36-#), or
wherein the elongation structure (32) comprises second elongation elements (42) which extend at least partially in the same plane as the second deflectable membrane structure (18) from the transducer element (12) to the second clamping structures (36-1, ..., 36-#).

2. The MEMS device (10) of claim 1, wherein the elongation structure (32) comprises first elongation elements (40) which extend at least partially in the same plane as the first deflectable membrane structure (14) from the transducer element (12) to the second clamping structures (24-1, ..., 24-#),
and
wherein the elongation structure (32) comprises second elongation elements (42) which extend at least partially in the same plane as the second deflectable membrane structure (18) from the transducer element (12) to the second clamping structures (36-1, ..., 36-#).

3. The MEMS device (10) of claims 1 or 2, wherein an originating portion (33) and a terminating portion (35) of the elongation structure (32) are in the same plane as the first deflectable membrane structure (14),
and/or
wherein an originating portion (33) and a terminating portion (35) of the elongation structure (32) are in the same plane as the second deflectable membrane structure (18).

4. The MEMS device (10) of claims 1 to 3, wherein the transducer element (12) is mechanically decoupled from the carrier element (22) at the unclamped edge regions (34-1, ..., 34-#) .

5. The MEMS device (10) of claims 1 to 4, wherein the elongation structure (32) comprises a corrugation element (54) extending parallel to the second clamping structures (36-1, ..., 36-#).

6. The MEMS device (10) of claims 1 to 5, wherein the elongation structure (32) comprises a slit or through-hole (58).

7. The MEMS device (10) of claims 1 to 6, wherein the first elongation elements (40) are formed as lateral elongations of the first deflectable membrane structure (14).

8. The MEMS device (10) of claims 1 to 6, wherein the second elongation elements (42) are formed as lateral elongations of the second deflectable membrane structure (18).

9. The MEMS device (10) of claims 1 to 8, wherein the edge clamping regions (26-1, ..., 26-#) of the transducer element (12) and the edge clamping regions (38-1, ..., 38-#) of the elongation structure (32) are arranged in an alternating order.

10. The MEMS device (10) of claims 1 to 9, wherein the carrier element (22) comprises a recess (46) and wherein the transducer element (12) and the elongation structure (32) are arranged to cover the recess (46) in the carrier element (22).

11. The MEMS device (10) of claim 1 to 10, further comprising a wall structure (44) at the unclamped edge regions (34-1, ..., 34-#) of the transducer element (12).

12. The MEMS device (10) of claim 11, wherein the first (14) and the second (18) deflectable membrane structures and the wall structure (44) together form a cavity (48) against the environment (50), wherein the cavity (48) is sealed against the environment (50) and the cavity (48) comprises a low pressure region, wherein the low pressure region comprises a reduced atmospheric pressure when compared to the environmental atmosphere.

13. The MEMS device (10) of any of the preceding claims, wherein the mechanical connection elements (20) comprise a plurality of pillar-shaped or a column-shaped mechanical connection elements between the two opposing deflectable membrane structures (14, 18).

14. The MEMS device (10) of any of the preceding claims, wherein the rigid electrode structure (16) forms a counter-electrode with respect to the first (14) and/or second (18) deflectable membrane structure.

15. The MEMS device (10) of any of the preceding claims, wherein the transducer element (12) has a microphone and/or loudspeaker functionality.
